# EUROPÄISCHE PATENTSCHRIFT

(11) **EP 1 212 797 B1**
(45) Veröffentlichungstag und Bekanntmachung des Hinweises auf die Patenterteilung: **15.11.2006**
(21) Anmeldenummer: 00967585.1
(22) Anmeldetag: 15.09.2000
(51) Int. Cl.: H01L 27/02

(54) **ESD-SCHUTZANORDNUNG FÜR SIGNALEINGÄNGE UND -AUSGÄNGE BEI HALBLEITERVORRICHTUNGEN MIT SUBSTRATTRENNUNG**
ESD-PROTECTIVE ARRANGEMENT FOR SIGNAL INPUTS AND OUTPUTS IN SEMICONDUCTOR DEVICES WITH SUBSTRATE SEPARATION
DISPOSITIF DE PROTECTION CONTRE LES DECHARGES ELECTROSTATIQUES POUR ENTREES ET SORTIES DE SIGNAUX DE DISPOSITIFS A SEMI-CONDUCTEUR AVEC SEPARATION DU SUBSTRAT

(30) Priorität: 16.09.1999 DE 19944489
(43) Veröffentlichungstag der Anmeldung: 12.06.2002
(73) Patentinhaber: Infineon Technologies AG, 81669 München (DE)
(72) Erfinder: GOSSNER, Harald, 85521 Riemerling (DE)
(74) Vertreter: Kottmann, Heinz Dieter
(86) Internationale Anmeldenummer: PCT/DE2000/003252
(87) Internationale Veröffentlichungsnummer: WO 2001/020678

(56) Entgegenhaltungen:
- US-A- 5 290 724
- US-A- 5 361 185
- US-A- 5 442 217

## Beschreibung

Die vorliegende Erfindung betrifft eine ESD-Schutzanordnung (ESD = electrostatic discharge) für Signaleingänge und -ausgänge (I/O) bei Halbleitervorrichtungen mit Substrattrennung, bei der ein Halbleitersubstrat mit einem Substratbus zum Beaufschlagen des Halbleitersubstrats mit einem Substratpotential VSSB und eine Halbleiterdiffusionszone im Halbleitersubstrat mit einem Powerbus (Leistungsbus) zum Beaufschlagen der Halbleiterdiffusionszone mit einem Powerpotential VSSP verbunden sind, bei der zwischen dem Substratbus und dem Powerbus eine parasitäre Diode liegt, bei der über einen Versorgungsbus den mit I/O-Pads (bzw. Eingabe/Ausgabe-Kontaktkissen) versehenen Halbleitervorrichtungen ein Versorgungspotential VDDP zuführbar ist und bei der zwischen dem Substratbus und dem Versorgungsbus eine in Flußrichtung betriebene Durchbruchdiode liegt. Die Diffusionszone kann beispielsweise als Source von Treibern genutzt sein.

ESD-Schutzanordnungen sind bekanntlich erforderlich, um integrierte Schaltungen vor überspannungen zu schützen. Solche überspannungen können beispielsweise durch Reibung infolge einer Ortsverlagerung der integrierten Schaltung oder durch deren Berührung durch einen Operator ("human body model") auftreten. ESD-feste Halbieitervorrichtungen sollen Spannungen bis in die Größenordnungen von einigen kV und Ströme bis in die Größenordnung von einigen A aushalten können. Um diese ESD-Festigkeit zu erzielen, müssen die entsprechenden Busse zur Vermeidung von hohen Spannungsabfällen auf den Busleitungen, insbesondere der Substratbus mit dem Substratpotential VSSB und der Powerbus mit dem Potential VSSP niederohmig gehalten werden. Hierzu ist es erforderlich, in Abhängigkeit von der Busbreite und dem Flächenwiderstand des Busses in definierten Abständen zu äußeren Pins (bzw. Anschlüssen) zu bonden. Diese Abstände können in der Größenordnung von 1 mm liegen,

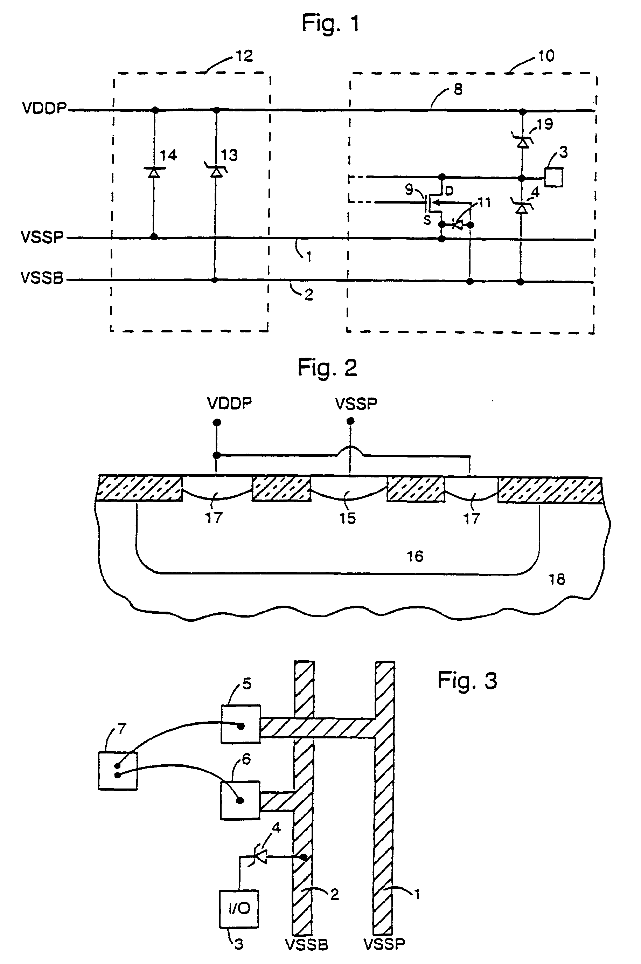

Fig. 3 zeigt eine bestehende Anordnung, bei der ein Substratbus 2 für Substratpotential VSSB und ein Powerbus 1 für das Potential VSSP vorgesehen sind. Das Substratpotential VSSB ist relativ "ruhig", während das Potential VSSP durch die Schaltvorgänge von Treibern im Vergleich zu dem Substratpotential VSSB Schwankungen von mehreren hundert mV unterworfen sein kann und als relativ "unruhig" anzusehen ist. Der Substratbus 2 ist über eine Durchbruchdiode 4, beispielsweise eine Zener-Diode, mit einem I/O-Pad 3 verbunden, um ESD-Entladungen auf den Substratbus 2 abführen zu können.

Zur Gewährleistung der ESD-Festigkeit sind beide Busse 1, 2 in regelmäßigen Abständen über Pads 5, 6 mit einem äußeren Pin 7 gebondet. In Fig. 3 sind zur Vereinfachung der Darstellung jeweils lediglich ein Pad 5 bzw. 6 und ein Pin 7 gezeigt. Dabei sind jeweils ein Pad 5 und ein Pad 6 über einen Doppelbond mit einem Pin 7 zu verbinden. Auf diese Weise können die jeweiligen Busse 1, 2 bzw. die auf diesen Bussen 1, 2 vorgesehenen Schutzstrecken niederohmig gehalten werden, wenn die Pads 5, 6 beispielsweise in einem Abstand von 1 mm mit jeweils einem Pin 7 gebondet werden.

Ein Nachteil dieser bestehenden ESD-Schutzanordnung ist aber darin zu sehen, daß für das unter regelmäßigen Abständen vorzunehmende Bonden beispielsweise des Substratbusses 2 eine große Anzahl von entsprechenden Pads zur Verfügung gestellt werden muß, so daß für das Bonden dieser Pads mehr Pins benötigt werden, als überhaupt verfügbar sind.

Es entsteht so eine ESD-Schutzanordnung, bei der die Halbleitervorrichtungen gegen das untere Versorgungspotential VSS im Bereich der I/O-Pads 3, bei denen die erwähnten Überspannungen vorzugsweise auftreten, unter einer sogenannten Substrattrennung sowohl mit dem Substratbus 2 als auch mittels beispielsweise Source eines Treibertransistors mit dem Powerbus 1 verbunden sind. Dadurch ist es überdies möglich, eine zwischen Halbleitersubstrat und Diffusionszone vorhandene parasitäre Diode zu nutzen, so daß nur einer der beiden Busse 1, 2 breiter ausgeführt zu werden braucht.

Alternativ könnte auch daran gedacht werden, die Busse 1, 2 für Potential VSSP bzw. Substratpotential VSSB durch Paare antiparalleler Dioden miteinander zu koppeln. Dieses Vorgehen führt aber bei einem positiven Verziehen des Potentials VSSP, wie dieses beim Schalten von Treibern auftreten kann, zu einer Störung auf dem Substratbus 2 und damit auch zu Störungen an empfindlichen Schaltungsteilen.

US 5,442,217 beschreibt eine Halbleitervorrichtung mit mehreren Schutzelementen zum Schutz einer innerhalb der Halbleitervorrichtung enthaltenen Schaltung vor elektrostatischer Entladung. Die Halbleitervorrichtung weist mehrere Anschlüsse einschließlich eines Ground-Anschlusses, eines Substratbias-Anschlusses, eines Leistungsversorgungsanschlusses und eines Eingangs-/Ausgangs-Signalanschlusses auf. Mehrere Schutzelemente sind zwischen verschiedenen dieser Anschlüsse verschaltet, um einen Entladepfad für eine Vielzahl von Entladungsszenarios bereitzustellen.

Es ist daher Aufgabe der vorliegenden Erfindung, eine ESD-Schutzanordnung anzugeben, bei der die Anzahl der Pads des Substratbusses und damit auch die Anzahl der Pins zum Bonden dieser Pads verringert werden kann.

Diese Aufgabe wird bei einer ESD-Schutzanordnung der eingangs genannten Art dadurch gelöst, daß zwischen dem Powerbus und dem Versorgungsbus eine zusätzliche, in Flußrichtung betriebene ESD-Diode vorgesehen ist. Die Erfindung ist in Patentanspruch 1 definiert.

Bei der erfindungsgemäßen ESD-Schutzanordnung ist also zusätzlich zu bestehenden Schutzanordnungen noch eine ESD-Diode zwischen dem Powerbus mit dem Potential VSSP und dem Versorgungsbus mit dem Versorgungspotential VDDP beispielsweise bei jedem Versorgungspad des Versorgungsbusses eingefügt. Diese ESD-Diode schließt den Schutzpfad für negative Belastungen zwischen dem Substratpotential VSSB und dem Potential VSSP während eines ESD-Stresses und begrenzt die auftretende Spannungsdifferenz zwischen den beiden entsprechenden Bussen, also dem Substratbus und dem Powerbus, auf die Klemmenspannung der Durchbruchdiode zuzüglich der Flußspannung der ESD-Diode. Die ESD-Diode zwischen dem Powerbus und dem Versorgungsbus soll nur in Flußrichtung betrieben werden. Dies erfordert, daß die Durchbruchspannung der ESD-Diode deutlich über der Durchbruchspannung der Durchbruchdiode des Versorgungsbusses liegt.

Bei positiven Belastungen, die über den Substratbus ausgeführt werden, kommt die parasitäre Diode zwischen Substrat bzw. Diffusionszone oder Halbleiterwanne und Source eines NMOS-Treibertransistors in Flußrichtung und begrenzt so die Spannungsdifferenz zwischen den beiden Bussen, also dem Substratbus und dem Powerbus auf niedrige Werte, sofern diese parasitäre Diode in geeigneter Weise ausgeführt ist, d.h., eine ausreichende Weite und einen für ESD optimierten Elektrodenabstand besitzt. Hierzu werden die Pads für den Versorgungsbus und den Powerbus sowie die I/O-Pads in einem geeigneten Abstandsraster angebracht.

Nachfolgend wird die Erfindung anhand der Zeichnungen näher erläutert. Es zeigen:
- Fig. 1: ein Schaltbild der erfindungsgemäßen ESD-Schutzanordnung,
- Fig. 2: eine Schnittdarstellung durch eine Halbleitervorrichtung mit einem Beispiel für eine ESD-Diode der erfindungsgemäßen ESD-Schutzanordnung und
- Fig. 3: eine Draufsicht auf einen Substratbus und einen Powerbus mit zugeordneten Pads bei einer bestehenden Schutzanordnung.

Die Fig. 3 ist bereits eingangs erläutert worden. In den Fig. 1 und 2 werden für einander entsprechende Bauteile die gleichen Bezugszeichen wie in Fig. 3 verwendet.

Fig. 1 zeigt den Powerbus 1 mit dem Potential VSSP, den Substratbus 2 mit dem Substratpotential VSSB und einen Versorgungsbus 8 mit dem Versorgungspotential VDDP. Die Potentiale VSSP und VSSB liegen bei etwa 0 V, während für das Versorgungspotential VDDP etwa 5 V zu veranschlagen ist.

Ein I/O-Pad 3 in einem Treiber 10 mit einem NMOS-Transistor 9 ist über Durchbruchdioden 4 und 19, wie beispielsweise ZenerDioden, mit dem Substratbus 2 einerseits und dem Versorgungsbus 8 andererseits verbunden und direkt an Drain D des NMOS-Transistors 9 angeschlossen, dessen Source auf dem Potential VSSP liegt und dessen Wanne mit dem Substratpotential VSSB verbunden ist. Zwischen Source und Wanne bildet sich eine parasitäre Diode 11 aus.

Jedem Versorgungspad (in Fig. 1 nicht näher dargestellt) des Versorgungspotentials VDDP ist ein ESD-Schutzglied 12 zugeordnet, das zunächst aus einer Durchbruchdiode 13, beispielsweise einer Zener-Diode, zwischen dem Substratbus 2 und dem Versorgungsbus 8 besteht. Außerdem hat erfindungsgemäß dieses ESD-Schutzglied 12 noch eine zusätzliche ESD-Diode 14 zwischen dem Versorgungsbus 8 und dem Wannenbus 1.

Diese ESD-Diode 14, bei der es sich um eine übliche pn-Diode handeln kann, schließt den Schutzpfad für negative Belastungen zwischen dem Substratbus 2 und dem Powerbus 1 während eines ESD-Stresses und begrenzt die auftretende Spannungsdifferenz zwischen den beiden Bussen 1 und 2 auf die Klemmenspannung der Durchbruchdiode 13 zuzüglich der Fluß spannung der ESD-Diode 14. Die ESD-Diode 14, die zwischen dem Powerbus 1 und dem Versorgungsbus 8 liegt, wird nur in Flußrichtung betrieben. Hierzu ist ihre Durchbruchspannung deutlich über der Durchbruchspannung der Durchbruchdiode 13 am Versorgungsbus 8. Bei positiven Belastungen, die über dem Substratbus 2 auftreten, wird die parasitäre Diode 11 zwischen Source des NMOS-Transistors 9, die am Powerbus 1 angeschlossen ist, und dem Substratbus 2 in Durchflußrichtung betrieben und begrenzt so die Spannungsdifferenz zwischen den beiden Bussen 1 und 2 auf niedrige Werte.

Fig. 2 zeigt ein Ausführungsbeispiel zur Realisierung der ESD-Diode 14 aus einem p⁺-leitenden Gebiet 15, an welchem das Potential VSSP anliegt, und einer n-leitenden Halbleiterwanne 16 mit n⁺-leitenden Kontaktgebieten 17 für das Versorgungspotential VDDP in einem p-leitenden Halbleitersubstrat 18.

Die erfindungsgemäße ESD-Schutzanordnung ermöglicht so eine vorteilhafte Ausnutzung der Pads 5 (vgl. Fig. 3) des Powerbusses 1 zur Ableitung des ESD-Pulses, ohne daß ein Pad 6 für den Substratbus 2 eingeführt werden muß. Dies verringert die Anzahl der erforderlichen Pads im "Padkranz" und vermeidet die Ausführung von Doppelbonds, die sich je nach Gehäuseart schwierig gestalten kann.

## Patentansprüche

1. ESD-Schutzanordnung für Signaleingänge und -ausgänge (I/O) bei mit I/O-Pads (3) versehenen Halbleitervorrichtungen (10) mit Substrattrennung, umfassend:
- ein Halbleitersubstrat (18), das mit einem Substratbus (2) zum Beaufschlagen des Halbleitersubstrats (18) mit einem Substratpotential (VSSB) verbunden ist, sowie eine Halbleiterdiffusionszone im Halbleitersubstrat (18), die mit einem Powerbus (1) zum Beaufschlagen der Halbleiterdiffusionszone mit einem Powerpotential (VSSP) verbunden ist,
- eine parasitäre Diode (11), die zwischen dem Substratbus (2) und dem Powerbus (1) ausgebildet ist und mit ihrer Kathode am Powerbus (1) und mit ihrer Anode am Substratbus (2) liegt,
- einen Versorgungsbus (8), über den den Halbleitervorrichtungen (10) ein Versorgungspotential (VDDP) zuführbar ist,
**gekennzeichnet durch**
- eine Durchbruchdiode (13), die zwischen dem Substratbus (2) und dem Versorgungsbus (8) ausgebildet ist und mit ihrer Kathode am Versorgungsbus (8) und mit ihrer Anode am Substratbus (2) liegt; und
- eine zwischen dem Powerbus (1) und dem Versorgungsbus (8) vorhandene zusätzliche ESD-Diode (14), die von einer parasitären Diode verschieden ist, deren Durchbruchspannung höher ist als die Durchbruchspannung der Durchbruchdiode (13) und die mit ihrer Kathode am Versorgungsbus (8) und mit ihrer Anode am Powerbus (1) liegt.

2. ESD-Schutzanordnung nach Anspruch 1,
**dadurch gekennzeichnet,**
**dass** die Halbleitervorrichtung (10) einen Treiber umfaßt.

3. ESD-Schutzanordnung nach Anspruch 2,
**dadurch gekennzeichnet,**
**dass** der Treiber einen NMOS-Transistor (9) aufweist.

4. ESD-Schutzanordnung nach Anspruch 3,
**dadurch gekennzeichnet,**
**dass** die parasitäre Diode (11) zwischen Source (S) des NMOS-Transistors (9) und dem Substratbus (2) liegt.

## Claims

1. ESD protection arrangement for signal inputs and outputs (I/O) in semiconductor devices (10) provided with I/O pads (3), with substrate isolation, comprising:
- a semiconductor substrate (18), which is connected to a substrate bus (2) for applying a substrate potential (VSSB) to the semiconductor substrate (18), and also a semiconductor diffusion zone in the semiconductor substrate (18), which is connected to a power bus (1) for applying a power potential (VSSP) to the semiconductor diffusion zone
- a parasitic diode (11) formed between the substrate bus (2) and the power bus (1) and connected by its cathode to the power bus (1) and by its anode to the substrate bus (2),
- a supply bus (8), via which a supply potential (VDDP) can be fed to the semiconductor devices (10),
**characterized by**
- a breakdown diode (13) formed between the substrate (2) and the supply bus (8) and connected by its cathode to the supply bus (8) and by its anode to the substrate bus (2); and
- an additional ESD diode (14), which is present between the power bus (1) and the supply bus (8), which is different from a parasitic diode, the breakdown voltage of which is higher than the breakdown voltage of the breakdown diode (13) and which is connected by its cathode to the supply bus (8) and by its anode to the power bus (1).

2. ESD protection arrangement according to Claim 1,
**characterized**
**in that** the semiconductor device (10) comprises a driver.

3. ESD protection arrangement according to Claim 2,
**characterized**
**in that** the driver has an NMOS transistor (9).

4. ESD protection arrangement according to Claim 3,
**characterized**
**in that** the parasitic diode (11) is located between the source (S) of the NMOS transistor (9) and the substrate bus (2).

## Revendications

1. Dispositif de protection vis-à-vis des décharges électrostatiques d'entrées et de sorties (I/O) de signal dans des dispositifs (10) à semi-conducteurs munis de plages (3) I/O à séparation du substrat, comprenant :
- un substrat (18) semi-conducteur, qui est relié à un bus (2) de substrat pour appliquer au substrat (18) semi-conducteur un potentiel (VSSB) de substrat, ainsi qu'une zone de diffusion de semi-conducteur dans le substrat (18) semi-conducteur, qui est reliée à un bus (1) de puissance pour appliquer un potentiel (VSSP) à la zone de diffusion de semi-conducteur,
- une diode (11) parasite qui est formée entre le bus (2) de substrat et le bus (1) de puissance et qui est reliée par sa cathode au bus (1) de puissance et par son anode au bus (2) de substrat,
- un bus (8) d'alimentation, par lequel un potentiel (VDDP) d'alimentation peut être appliqué aux dispositifs (10) à semi-conducteur,
**caractérisé par**
- une diode (13) à claquage, qui est formée entre le bus (2) de substrat et le bus (8) d'alimentation et qui est reliée par sa cathode au bus (8) d'alimentation et par son anode au bus (2) de substrat ; et
- une diode (14) supplémentaire de décharge électrostatique présente entre le bus (1) de puissance et le bus (8) d'alimentation et distincte d'une diode parasite, dont la tension de claquage est plus haute que la tension de claquage de la diode (13) à claquage et qui est reliée par sa cathode au bus (8) d'alimentation et par son anode au bus (1) de puissance.

2. Dispositif de protection vis-à-vis des décharges électrostatiques suivant la revendication 1,
**caractérisé**
**en ce que** le dispositif (10) à semi-conducteur comprend un dispositif d'attaque.

3. Dispositif de protection vis-à-vis des décharges électrostatiques suivant la revendication 2,
**caractérisé**
**en ce que** le dispositif d'attaque a un transistor (9) NMOS.

4. Dispositif de protection vis-à-vis des décharges électrostatiques suivant la revendication 3,
**caractérisé**
**en ce que** la diode (11) parasite se trouve entre la source (S) du transistor (9) NMOS et le bus (2) de substrat.
